# FASCICULE DE BREVET EUROPEEN

(11) **EP 3 092 604 B1**
(45) Date de publication et mention de la délivrance du brevet: **09.12.2020**
(21) Numéro de dépôt: 14812545.3
(22) Date de dépôt: 16.12.2014
(51) Int. Cl.: G06K 19/077

(54) **MODULE ÉLECTRONIQUE, SON PROCÉDÉ DE FABRICATION, ET DISPOSITIF ÉLECTRONIQUE COMPRENANT UN TEL MODULE**
ELEKTRONISCHES MODUL, SEIN HERSTELLUNGSVERFAHREN UND DIESES MODUL UMFASSENDE ELEKTRONISCHE VORRICHTUNG
ELECTRONIC MODULE, METHOD FOR MANUFACTURING SAME AND ELECTRONIC DEVICE INCLUDING SUCH A MODULE

(30) Priorité: 06.01.2014 EP 14305010
(43) Date de publication de la demande: 16.11.2016
(73) Titulaire: Thales Dis France SA, 92190 Meudon (FR)
(72) Inventeur: LE LOC'H, Alain, 13881 Gemenos Cedex (FR); BERTOLOTTI, Jean-Marie, 13881 Gemenos Cedex (FR); FIDALGO, Jean-Christophe, 13881 Gemenos Cedex (FR)
(86) Numéro de dépôt international: PCT/EP2014/078085
(87) Numéro de publication internationale: WO 2015/101489

(56) Documents cités:
- WO-A1-97/26621
- WO-A1-98/33143
- WO-A1-2004/079647
- FR-A1- 2 880 160

## Description

### [Domaine de l'inventionl

L'invention concerne le domaine technique des modules électroniques comprenant au moins un composant électronique, par exemple de type puce de circuit intégré, et destinés de préférence à connecter électriquement ce composant électronique à un circuit électrique. L'invention se rapporte également à un procédé de fabrication d'un tel module. Elle se rapporte enfin à des dispositifs électroniques comprenant un tel module électronique. De tels dispositifs peuvent se présenter par exemple sous forme de carte, d'étiquette, de ticket ou de livret et trouvent des applications notamment, mais non exclusivement, dans le contrôle d'accès, les transports, l'identification ou le paiement par exemple. Au sens large, un module peut être également un circuit imprimé.

### [Art Antérieur]

Il existe aujourd'hui différents types de dispositifs électroniques. Il existe notamment des dispositifs fonctionnant à contact, des dispositifs fonctionnant sans contact, des dispositifs dits « mixtes » fonctionnant avec et/ou sans contact, et des dispositifs dits « interconnectés » comprenant un ou plusieurs autres circuits électriques ou électroniques, connectés électriquement au module électronique et plus particulièrement au composant semi-conducteur qu'il renferme. De tels circuits électriques, notamment interconnectés, peuvent comprendre par exemple une antenne radio fréquence ou une antenne ultra haute fréquence et /ou un ou plusieurs composants électriques ou électroniques connecté(s) électriquement au composant semi-conducteur.

Dans l'art antérieur qui suit, on se placera notamment dans l'application préférée d'un dispositif électronique mixte ou d'un dispositif interconnecté, comprenant un module électronique, disposé dans une cavité ménagée dans le corps du dispositif, et destiné à être connecté électriquement à (ou connectant) au moins un autre circuit électrique. Ce dernier circuit électrique peut comprendre ou non, un ou plusieurs autres composants électriques/électroniques.

En général, pour ce type de dispositif, on utilise des modules électroniques dits « double face », qui comprennent une couche de cuivre assemblée sur chaque face d'un film support diélectrique. Un tel module double face est donc formé par assemblage d'un film diélectrique et de deux couches métallisées. La première couche métallisée est gravée pour délimiter les contours des plages de contact d'un bornier de connexion destiné à affleurer la surface du dispositif électronique dans lequel le module est inséré. La deuxième couche métallisée est gravée pour délimiter les contours de pistes conductrices. On peut en outre faire subir à ces deux couches métallisées un traitement de surface consistant à rajouter une couche de métallisation additionnelle, à base de Nickel et d'Or, formant une couche de passivation et les protégeant ainsi de l'oxydation. Sur la face du film diélectrique supportant la deuxième couche métallisée gravée sous forme de pistes conductrices, est fixé un composant semi-conducteur tel qu'une puce de circuit intégré par exemple.

Classiquement, la puce est fixée sur le film diélectrique, sa face active tournée vers l'extérieur du film, et ses plots de contact sont connectés aux plages de contact du bornier de connexion par une technique bien connue sous la dénomination anglo-saxonne « wire bonding », consistant à utiliser des fils métalliques en or, aluminium, cuivre ou argent et à les faire passer à travers des réservations pratiquées dans l'épaisseur du film diélectrique, au regard des plages de contact à connecter. Les plots de contact de la puce sont en outre connectés aux pistes conductrices de la deuxième couche métallisée. La puce et les fils de connexion sont ensuite enrobés dans une résine de protection.

Cependant, un tel module double face nécessitant l'utilisation de deux couches métallisées revient cher. Le marché des dispositifs électroniques mixtes ou des dispositifs interconnectés est en pleine expansion et des modules électroniques de type double face doivent être produits en masse. Un tel module, de type double face, doit donc présenter une grande fiabilité et un prix de revient le plus bas possible.

Une solution alternative a été envisagée dans le passé pour réduire les coûts de revient d'un module double face. Cette solution, décrite dans la demande de brevet WO2000043951, consiste à réaliser une seule couche métallisée et à utiliser les plages de contact pour établir des connexions électriques entre les entrée/sorties du composant semi-conducteur et les bornes d'interconnexion d'une antenne. Cependant, cette solution n'est pas adaptable aux différentes configurations de puces de circuit intégré existantes, si bien qu'il faut prévoir autant de conceptions de modules électroniques qu'il y a de puces différentes. Par conséquent, cette solution est encore trop coûteuse pour une production industrielle à grande échelle.

Les document WO 2004/079647 A1 et WO 98/33143 A1 divulguent un module de carte à puce à double interface contact et sans contact. Le module comprend une face supérieure comportant des plages de contact et une face inférieure opposée portant des pistes et plages d'interconnexion à une antenne. Toutes les plages et les pistes du module sont réalisées par technique de circuit imprimé. Cela signifie que les surfaces métalliques sont gravées chimiquement comme les circuits imprimés de l'industrie électronique. La technique utilisée est soustractive par enlèvement chimique des surfaces métalliques non désirée. Le document WO 97/26621 A1 décrit un module de carte à puce pouvant être à interface duale (contacts et sans contact) ou pouvant intégrer uniquement une antenne. L'antenne peut être obtenue par gravure ou par dépôt de matière métallique.

### [Problème technique]

L'invention a donc pour but de remédier à au moins un des inconvénients de l'art antérieur.

En particulier, l'invention vise à proposer une solution simple et peu coûteuse pour réaliser un module électronique notamment de type double face, apte à permettre une connexion électrique entre le composant électronique qu'il renferme et un autre circuit électrique ou électronique, le module étant en outre adaptable à n'importe quelle configuration de composant électronique.

### [Résumé de l'invention]

Le principe de l'invention repose sur le fait qu'on réalise, sur la face du film diélectrique des pistes conductrices par un procédé d'impression. la connexion d'un composant aux pistes conductrices s'effectue de préférence directement par fil électriquement conducteur ou par l'intermédiaire d'une îlot ou portion de surface ou plage conductrice d'interconnexion. On peut donc imprimer et adapter la forme des pistes à un composant semi-conducteur, en dernière minute. On peut éviter le coût élevé de la gravure. Le procédé n'utilise que peu de matière pour former des métallisations. On peut utiliser contrairement à la pratique à l'égard d'une impression de métallisation, un mode de connexion économique par fil conducteur.

Le film peut comporter, sur la face opposée à celle comportant les pistes imprimées, d'autres pistes ou plages électriquement conductrices réalisées classiquement par gravure (comme les circuits imprimés) ou les modules de carte à puce pour former un film avec des pistes ou surfaces conductrices sur les deux faces (double face). Ces autres pistes ou plages ou surfaces électriquement conductrices peuvent être également réalisées par un procédé d'impression sur le film support (ou un support isolant).

A cet effet, l'invention a pour objet un module électronique selon la revendication 1.

Ainsi, les pistes ne sont imprimées qu'aux endroits nécessaires pour permettre l'établissement d'une connexion électrique et on utilise une quantité de métal bien inférieure à une celle d'une couche métallisée que l'on grave ensuite. Le fait d'imprimer les pistes conductrices avec une encre métallique ou matière conductrice électriquement permet donc de réduire considérablement les coûts de revient du module. De plus, le fait d'imprimer les pistes conductrices permet d'adapter et de personnaliser le module à n'importe quelle configuration de composant électronique.

Selon d'autres caractéristiques optionnelles du module électronique :
- chaque piste conductrice imprimée comprend une deuxième extrémité formant une plage d'interconnexion destinée à être électriquement connectée à une borne d'interconnexion dudit circuit électrique,
- le film support diélectrique porte en outre, sur une deuxième face, une pluralité de plages de contact électriques, ledit composant semi-conducteur étant électriquement relié auxdites plages de contact électriques,
- une première extrémité du fil conducteur est fixée sur le plot de contact dudit composant semi-conducteur tandis que l'autre extrémité du fil conducteur passe à travers une réservation, pratiquée dans l'épaisseur du film diélectrique au regard d'un îlot de contact délimité dans une plage de contact, et est fixée sur ledit 'îlot de contact, et la première extrémité de la piste conductrice imprimée est réalisée dans ladite réservation, sur la surface dudit îlot de contact et débouche à la surface de la première face dudit film support diélectrique,
- le matériau de constitution des pistes conductrices imprimées est compatible avec le matériau de constitution du fil conducteur et réciproquement.
- le matériau de constitution des pistes conductrices imprimées est une encre conductrice comprenant des nanoparticules métalliques à base de l'un au moins des métaux suivants : or, argent, cuivre, aluminium, palladium, ou des mélanges à base de nanoparticules de cuivre enrobées d'étain, de nanoparticules de cuivre enrobées d'argent, de nanoparticules de cuivre enrobées de palladium, ou encore de nanoparticules de cuivre enrobées d'une couche de Ni/Au,
- le circuit électrique comprend une antenne radio fréquence, une antenne ultra haute fréquence, et/ou tout circuit électrique supportant au moins un autre composant semi-conducteur,
- le circuit électrique est une antenne réalisée sur la surface de la première face dudit film support diélectrique,
- avantageusement, cette antenne est également réalisée par impression d'encre conductrice,
- le circuit électrique est extérieur au module et noyé dans le corps d'un dispositif électronique dans lequel ledit module est destiné à être inséré,
- le circuit électrique peut comprendre une piste et/ou zone conductrice réalisée par impression d'encre (ou matière) conductrice sur le film support.
L'invention vise également à proposer un procédé de fabrication d'un module électronique selon la revendication 10.

De préférence, le procédé comprend une étape d'enrobage ou de protection au moins partiel du composant semi-conducteur et ses connexions par une résine de protection. On peut aussi effectuer une protection autrement par une cavité ou un couvercle protecteur.

Selon d'autres caractéristiques optionnelles du procédé de fabrication :
- le procédé comprend en outre une étape préalable consistant à assembler une couche métallisée sur une deuxième face du film support diélectrique, à réaliser une pluralité de plages de contact électriques dans ladite couche métallisée, et à connecter électriquement ledit composant semi-conducteur auxdites plages de contact électriques,
- la deuxième extrémité de chaque piste conductrice imprimée est réalisée sur une surface telle, qu'elle forme une plage d'interconnexion destinée à être électriquement connectée à une borne d'interconnexion dudit circuit électrique
- chaque extrémité du fil conducteur est fixée d'une part sur un plot de contact du composant semi-conducteur et d'autre part sur un îlot de contact électrique, dont les contours sont préalablement délimités dans une plage de contact, en passant à travers une réservation pratiquée dans l'épaisseur du film diélectrique au regard dudit îlot de contact, de sorte qu'il relie électriquement ledit plot de contact du composant semi-conducteur audit îlot de contact, et en ce que la première extrémité de la piste conductrice à relier est imprimée sur la surface dudit îlot de contact dans ladite réservation et débouche sur la face du film diélectrique supportant ledit composant semi-conducteur,
- l'impression des pistes conductrices est réalisée par l'une des techniques suivantes : jet d'encre, spray, LIFT, sérigraphie, flexographie ou encore héliographie.

L'invention se rapporte enfin à un dispositif électronique comprenant un circuit électrique noyé dans son corps, et un module électronique inséré dans une cavité ménagée dans son corps, ledit circuit électrique comprenant des bornes d'interconnexion à connecter audit module, caractérisé en ce que le module électronique est conforme au module décrit ci-dessus, ses plages d'interconnexion, formées par la deuxième extrémité des pistes conductrices imprimées sur le film diélectrique, sont disposées en regard des bornes d'interconnexion dudit circuit électrique et la connexion électrique entre lesdites plages d'interconnexion dudit module et lesdites bornes d'interconnexion dudit circuit électrique comprend un matériau conducteur électrique.

Ce dispositif constitue avantageusement un dispositif mixte à fonctionnement à contact et/ou sans contact, ou un dispositif interconnecté multi-composants. A titre d'exemple, ce peut être une carte à puce avec et/ou sans contact, un ticket avec et/ou sans contact, une étiquette avec et/ou sans contact, ou un livret de type passeport.

### [Brève description des figures]

D'autres particularités et avantages de l'invention apparaitront à la lecture de la description suivante faite à titre d'exemple illustratif et non limitatif, en référence aux Figures annexées qui représentent :
- La Figure 1, un schéma d'un module électronique selon l'invention vu par sa face supportant un composant semi-conducteur,
- La Figure 2, un schéma d'un module électronique vu par sa face supportant un composant semi-conducteur, selon une variante de réalisation,
- La Figure 3, un schéma d'un module électronique vu par sa face supportant un composant semi-conducteur, réalisé selon un autre mode de réalisation,
- La Figure 4, un schéma d'un module électronique vu par sa face supportant un composant semi-conducteur et une antenne radiofréquence,
- La Figure 5, un schéma en coupe d'un exemple de dispositif électronique comprenant un module selon l'invention, connecté à un circuit électrique noyé dans le corps dudit dispositif.

### [Description]

Les dispositifs électroniques peuvent se présenter sous différentes formes telles qu'une carte avec et/ou sans contact, une étiquette, un ticket, ou même un livret lorsqu'il s'agit d'un passeport d'identité par exemple. Ces dispositifs doivent satisfaire des normes telles que la norme ISO 7816 lorsqu'il s'agit d'un dispositif à contact ou la norme ISO14443 lorsque le dispositif renferme une interface de communication se présentant sous la forme d'une antenne par exemple.

L'invention s'applique à tout type de dispositif électronique comprenant un circuit électrique électriquement relié au composant semi-conducteur du module électronique. Dans les exemples décrits ci-après, le circuit électrique comprend une antenne radio fréquence, ou une antenne ultra haute fréquence. Cependant, le dispositif selon l'invention ne se limite pas à cet exemple et le circuit électrique peut avantageusement comprendre une telle antenne et/ou tout autre composant électronique.

Le principe de l'invention selon le mode préféré consiste à éviter l'utilisation de deux couches métalliques, trop couteuses, pour la réalisation d'un module de type double face destiné à équiper ces dispositifs.

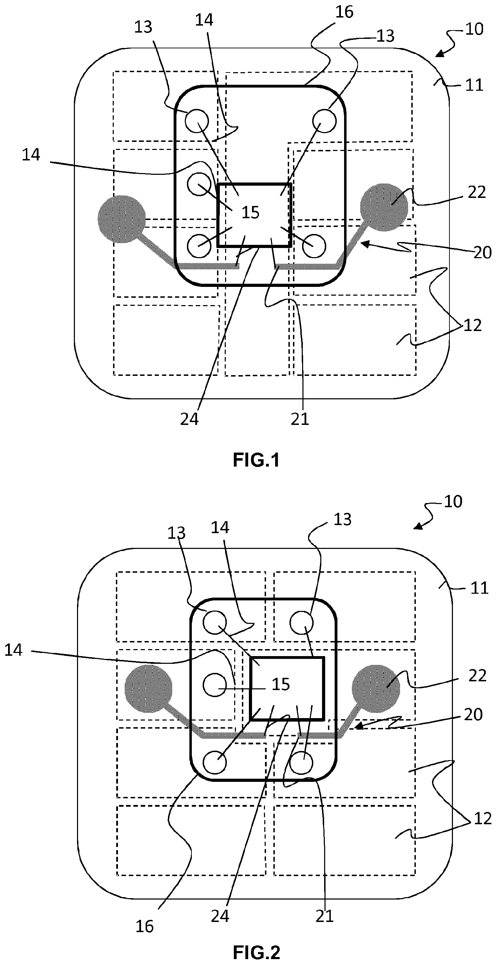

L'invention selon le mode préféré consiste donc à utiliser un module 10 standard, simple face, c'est-à-dire comprenant un film support diélectrique assemblé à une couche métallique sur une seule de ses faces. La Figure 1 illustre schématiquement un exemple d'un module électronique selon l'invention, vu de dessous, c'est-à-dire du côté de la face du film diélectrique 11 opposée aux plages de contact 12 électriques, représentées en traits pointillés sur la Figure 1. Les plages de contact 12 sont obtenues par gravure de la couche métallique assemblée au film diélectrique et forment un bornier de connexion destiné à affleurer la surface d'un dispositif électronique. De préférence, ces plages de contact subissent un traitement de surface consistant à rajouter une couche métallique additionnelle à base de nickel et d'or afin de former une couche de passivation. Le composant électronique 15, tel qu'une puce de circuit intégré par exemple, est alors reporté, par collage par exemple, sur la face du film diélectrique 11 opposée aux plages de contact 12. Des réservations 13, ou orifices, sont avantageusement pratiqués dans l'épaisseur du film diélectrique 11, au droit des plages de contact 12 à connecter au composant électronique 15. Les plots de contact du composant électronique 15 sont ensuite électriquement connectés aux plages de contact 12, par une technique classique dite de « wire bonding » en terminologie anglo-saxonne et consistant à utiliser des fils d'or, d'aluminium, d'argent ou de cuivre, et à les souder à chacune de leur extrémité respectivement à un plot de contact du composant semi-conducteur 15 et à une plage de contact 12 du bornier de connexion en faisant passer le fil dans une réservation 13 préalablement pratiquée dans l'épaisseur du film diélectrique 11.

Pour pouvoir créer un module de type double face à partir de ce module simple face, l'invention consiste ensuite à imprimer, sur la face du film diélectrique supportant le composant semi-conducteur 15, des pistes conductrices 20 permettant de relier électriquement le composant semi-conducteur 15 à un autre circuit électrique qui peut être extérieur au module, ou éventuellement sur la surface du film diélectrique 11 du module.

Dans ce cas, les pistes conductrices présentent deux extrémités. Une première extrémité 21 est destinée à être reliée électriquement à un plot de contact du composant semi-conducteur 15, tandis que l'autre extrémité 22 est imprimée sous la forme d'une plage d'interconnexion, présentant une surface supérieure à celle de la première extrémité. A titre d'exemple, la surface de cette plage d'interconnexion 22 pourra être de l'ordre de 1mm². Cette plage d'interconnexion est destinée à être électriquement connectée aux bornes d'interconnexion d'un circuit électrique, telles que par exemple les bornes d'extrémité d'une antenne radiofréquence.

Selon un premier mode de réalisation, et tel qu'illustré sur la Figure 1, la première extrémité de chaque piste conductrice est alors reliée électriquement à un plot de contact du composant semi-conducteur 15 par la technique classique de « wire bonding ». Pour cela, on fixe, par soudure par exemple, chaque extrémité d'un fil conducteur 24, tel qu'un fil d'or, d'aluminium, d'argent ou de cuivre par exemple, respectivement sur le plot de contact du composant semi-conducteur 15 et sur la première extrémité 21 d'une piste conductrice 20 imprimée. Le composant semi-conducteur et ses connexions électriques sont ensuite de préférence enrobées dans une résine de protection 16, à l'exception des plages d'interconnexion 22 définies par la deuxième extrémité des pistes conductrices imprimées et destinées à être électriquement connectées aux bornes d'interconnexion d'un circuit électrique.

Dans ce cas, la technique d'impression utilisée peut être une technique d'impression jet d'encre, spray ou LIFT (acronyme anglais pour « Laser Induced Forward Transfert ») qui est une technique de dépôt assisté par Laser, par sérigraphie, flexographie ou héliographie. De préférence, les pistes conductrices 20 sont imprimées par jet d'encre, spray ou LIFT.

Ces techniques d'impression utilisent une encre conductrice choisie parmi l'une au moins des encres suivantes : une encre à base de nanoparticules métalliques, comprenant par exemple de l'or, de l'argent, du cuivre, du Palladium, de l'aluminium, ou encore des mélanges à base de nanoparticules de cuivre enrobées d'étain, de nanoparticules de cuivre enrobées d'argent, de nanoparticules de cuivre enrobées de palladium, ou encore de nanoparticules de cuivre enrobées d'une couche de Ni/Au.

Ces encres présentent en outre une grande compatibilité avec les techniques de connexions utilisées dans les procédés de fabrication classiques de cartes, et notamment avec les techniques de connexion de type « wire bonding » ou à base de colle à argent. Une telle compatibilité permet l'obtention de connexions électriques de bonne qualité.

L'impression d'encre conductrice pour réaliser les pistes conductrice permet d'adapter le module en fonction de la configuration des plots de contact du composant semi-conducteur 15 à reporter sur le module. Par conséquent, la réalisation d'un tel module de type double face est très adaptable et peut être personnalisée en fonction du composant semi-conducteur 15 à reporter.

La réalisation des pistes conductrices 20 par impression d'encre conductrice n'utilise que peu de métal, surtout en impression par jet d'encre où l'épaisseur d'encre appliquée est faible et de l'ordre de quelques centaines de nm à quelques µm. De plus, on dépose l'encre métallique juste aux endroits nécessaires pour définir les pistes conductrices, si bien que la face du diélectrique supportant la puce ne comprend que très peu de métal, et présente de l'espace libre pouvant servir à y reporter d'autres composants et/ou circuit électrique. Le coût de revient d'un tel module est donc considérablement réduit par rapport à un module double face classique.

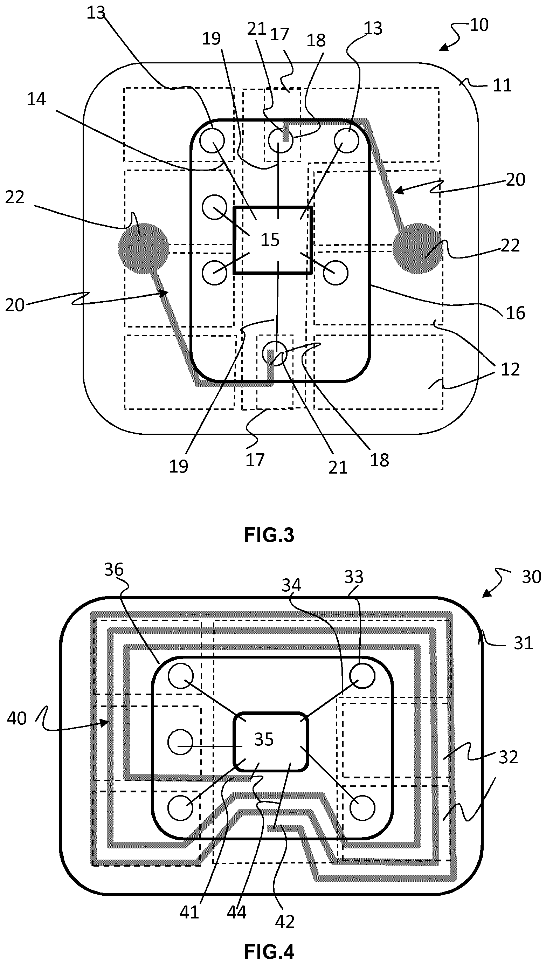

Lorsque l'épaisseur de l'encre est faible, notamment lorsque les pistes sont imprimées par la technique de jet d'encre qui implique un dépôt de faible épaisseur et n'utilisant que peu de matière, la connexion électrique avec un fil conducteur peut s'avérer délicate à réaliser. De plus, cette connexion risque de ne pas résister suffisamment aux contraintes de torsion ou de flexion, lors de la manipulation du dispositif électronique dans lequel le module est inséré. Dans ce cas, un deuxième mode de réalisation peut être envisagé afin de renforcer la robustesse de la liaison électrique entre un fil conducteur et une piste conductrice imprimée. Selon ce deuxième mode de réalisation, illustré sur la Figure 3, la connexion électrique entre une piste conductrice 20 imprimée et un plot de contact du composant semi-conducteur 15 est réalisée en utilisant un fil conducteur 19 et une portion de plage de contact en tant que point relai.

Selon ce deuxième mode de réalisation, on définit, pour chaque piste conductrice à connecter au composant semi-conducteur 15, un îlot 17 dans une plage de contact électrique 12 du bornier de connexion. Pour cela, on grave par exemple une portion de plage de contact, par exemple une portion de la plage réservée à la masse conformément à la norme ISO 7816. Le fait de graver une portion de plage de contact permet d'isoler un îlot de contact 17 et de s'en servir en tant que point relai dans une connexion électrique. L'ilot de contact 17 ainsi définit est alors relié électriquement par la technique classique de wire bonding à un plot du composant semi-conducteur 15, en passant un fil conducteur 19 dans une réservation 18 pratiquée dans l'épaisseur du film diélectrique 11 au droit de l'ilot de contact 17. L'extrémité 21 de la piste conductrice 20 imprimée devant être connectée à ce plot de contact est alors imprimée directement sur la surface de l'îlot de contact 17, dans la réservation 18 pratiquée au droit de l'ilot 17, et débouche sur la surface du diélectrique 11.

Pour pouvoir imprimer dans la réservation 18, dont les parois sont en général verticales, sans pour autant affecter la continuité électrique des pistes conductrices 20 qui débouchent sur la surface du film diélectrique 11, on préfère utiliser la technique d'impression par spray ou LIFT.

Un troisième mode de réalisation, illustré sur la Figure 2, consiste à reporter le composant semi-conducteur 15 sur le film diélectrique 11 de manière décentrée par rapport au bornier de connexion formé par les plages de contact 12 de la face opposée.

Un bornier de connexion de carte à puce conforme à la norme ISO 7816 comporte 6 ou 8 plages de contact 12 électriques utiles. Les plages de contact sont nommées C1 à C8 dans la norme ISO 7816-2. En outre la norme prévoit l'attribution des plages de contact à des signaux particulier: la plage C1 reçoit la tension d'alimentation Vcc, C2 supporte le signal RST d'initialisation, C3 correspond à un signal d'horloge CLK, C4 correspond au signal de données D+ pour une communication USB mais peut être utilisé pour autre chose que l'USB, C5 reçoit une tension de masse GND, C6 est destinée à recevoir une tension VPP de programmation de carte à mémoire mais n'est plus utilisée actuellement, C7 correspond à un signal I/O d'échange de données, et C8 correspond au signal de données D-pour une communication USB mais peut être utilisé pour autre chose que l'USB.

Le composant semi-conducteur 15 peut être reporté de manière décentrée par rapport au centre du bornier de connexion. Il peut par exemple être reporté en regard de la plage de contact normalisée C6 conformément à la norme ISO7816. Le fait de décentrer l'emplacement du composant semi-conducteur 15 par rapport au bornier de connexion, permet de gagner de la place à la surface du film diélectrique 11 en réduisant la zone d'enrobage 16 et en recentrant également les plages d'interconnexion 22 imprimées. De cette manière on libère de la place sur la face du film diélectrique 11 destinée à être fixée dans la cavité d'un corps de dispositif électronique. Cette place libérée permet par exemple d'augmenter la surface de collage du module dans la cavité d'un dispositif électronique et de renforcer ainsi la résistance du module à l'arrachement.

Dans une autre variante de réalisation, le gain de place engendré par l'impression des pistes conductrices 20 sur la face du film diélectrique 11, notamment lorsque la puce est reportée de manière décentrée, permet d'envisager la réalisation d'un circuit électrique directement sur le module électronique.

Dans un autre exemple, illustré sur la Figure 4, les pistes conductrices du module 30 peuvent d'ailleurs être confondues avec le circuit électrique, notamment lorsque celui-ci prend la forme d'une antenne radiofréquence 40 par exemple. Dans ce cas, l'antenne 40 peut être réalisée par impression d'encre conductrice à la surface du film diélectrique 31, autour du composant 35, et ses deux extrémités 41, 42 sont électriquement reliées à un plot de contact du composant semi-conducteur 35 au moyen d'un fil conducteur électrique 44. Le composant 35 et les fils de connexion peuvent être ensuite enrobés au moins partiellement dans une résine de protection 36. Dans le cas d'une antenne, des spires destinées à être chevauchées peuvent être isolées électriquement par un matériau isolant afin d'éviter un court-circuit. Le module peut ou non comprendre des plages de contact 32 (en pointillées) sur l'autre face opposée à celle 31 portant le circuit électrique imprimé par un procédé d'impression.

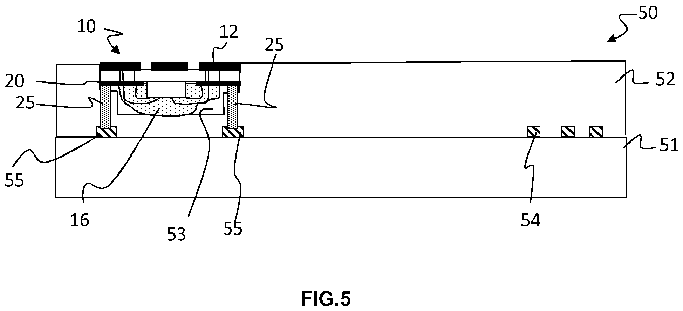

La Figure 5 schématise une vue en coupe d'un dispositif électronique 50 se présentant sous la forme d'une carte à puce mixte. Cette carte renferme une antenne 54, 55 radiofréquences. Le corps de carte comprend plusieurs couches, référencées 51 et 52 sur la Figure 5. Une cavité 53 ménagée dans le corps de carte est destinée à recevoir le module électronique 10 selon l'invention. Les bornes d'extrémité 55 de l'antenne se situent de part et d'autre de la cavité 53. Des puits 25 sont creusés dans le corps de carte, au droit des bornes d'extrémité 55 de manière à les découvrir. Puis, un matériau conducteur électrique, de type polymère conducteur par exemple, est utilisé pour remplir les puits 25 afin de connecter électriquement les bornes d'extrémité 55 de l'antenne noyée dans le corps de carte 51, 52, aux plages d'interconnexion 22 des pistes conductrices 20 imprimées sur la face cachée du module 10.

Le module de type double face qui vient d'être décrit présente l'avantage d'être très peu coûteux car il utilise très peu de métal sur sa deuxième face, opposée aux plages de contact. Il est de plus modulable car les pistes conductrices sont imprimées en fonction de la configuration du composant semi-conducteur à reporter. Par conséquent, le module utilisé est un module simple face, peu coûteux, qui est personnalisé par impression d'encre conductrice pour en faire un module de type double face, apte à relier électriquement son composant semi-conducteur à un circuit électrique disposé à l'extérieur du module ou sur une surface libre du film diélectrique du module.

Selon un autre aspect ou mode de l'invention, notamment dans le cadre de module sous forme de circuits électroniques imprimés (réalisés par impression d'encre ou matière conductrice), le circuit électrique (antenne, pistes, surfaces électriquement conductrices) auquel est connecté le composant du module (notamment puce électronique de semi-conducteur), peut comprendre une piste 20 et/ou zone conductrice 22 (Ces dernières peuvent être portées par le film support et réalisées par impression d'encre (ou matière) conductrice.

Le cas échéant, en cas de difficulté de soudure du fil de connexion entre un plot de puce et une piste et/ou surface réalisée par impression. Une extrémité du fil peut être connectée notamment par soudure sur une portion de surface ou plage métallique notamment gravée figurant de préférence (mais pas nécessairement) sur une face du film support recevant déjà des métallisations. Cette portion de surface ou plage d'interconnexion sert à interconnecter une extrémité du fil conducteur et une piste qui a été imprimée par procédé d'impression. Cette piste imprimée s'étend alors sur le film support et sur au moins une partie de cette plage d'interconnexion. L'autre extrémité opposée du fil conducteur est soudée à un plot de puce de semi-conducteur.

Dans le cas ou chaque portion de surface d'interconnexion est disposée sur la face portant les plages de contact ohmiques, le procédé prévoit d'isoler électriquement la portion de surface d'interconnexion des autres plages de contact notamment par une rainure périphérique comme l'ilot 17 (figure 3).

## Revendications

1. Module électronique (10) comprenant d'un film support diélectrique (11) avec une première face, des pistes conductrices (20) réalisées par impression de matière conductrice sur ladite première face, un composant semi-conducteur (15) connectant lesdites pistes par des connexions électriques, **caractérisé en ce que** chaque connexion comprend un fil conducteur électrique (19 ; 24) reliant un plot du composant semi-conducteur à chaque piste directement ou par l'intermédiaire d'un îlot ou d'une plage d'interconnexion (17).

2. Module électronique selon la revendication 1, **caractérisé en ce que** chaque piste conductrice (20) comprend une deuxième extrémité (22) formant une plage d'interconnexion destinée à être électriquement connectée à une borne d'interconnexion dudit circuit électrique.

3. Module électronique selon l'une des revendications 1 à 2, **caractérisé en ce que** le film support diélectrique (11) porte en outre, sur une deuxième face, une pluralité de plages de contact (12) électriques, ledit composant semi-conducteur (15) étant électriquement relié auxdites plages de contact (12) électriques.

4. Module électronique selon les revendications 1 et 3, **caractérisé en ce qu'**une première extrémité du fil conducteur (19) est fixée sur le plot de contact dudit composant semi-conducteur (15) tandis que l'autre extrémité du fil conducteur (19) passe à travers une réservation (18), pratiquée dans l'épaisseur du film diélectrique (11) au regard d'un îlot de contact (17) délimité dans une plage de contact (12), et est fixée sur ledit îlot de contact (17), et **en ce que** la première extrémité (21) de la piste conductrice (20) imprimée est réalisée dans ladite réservation (18), sur la surface dudit îlot de contact (17) et débouche à la surface de la première face dudit film support diélectrique (11).

5. Module électronique selon l'une des revendications 1 à 4, **caractérisé en ce que** le matériau de constitution des pistes conductrices (20) imprimées est compatible avec le matériau de constitution du fil conducteur (19 ; 24) et réciproquement.

6. Module électronique selon l'une des revendications 1 à 5, **caractérisé en ce que** le matériau de constitution des pistes conductrices (20) imprimées est une encre conductrice comprenant des nanoparticules métalliques à base de l'un au moins des métaux suivants : or, argent, cuivre, aluminium, palladium, ou des mélanges à base de nanoparticules de cuivre enrobées d'étain, de nanoparticules de cuivre enrobées d'argent, de nanoparticules de cuivre enrobées de palladium, ou encore de nanoparticules de cuivre enrobées d'une couche de Ni/Au.

7. Module électronique selon l'une des revendications 1 à 6, **caractérisé en ce que** le circuit électrique comprend une antenne radio fréquence, une antenne ultra haute fréquence, et/ou tout circuit électrique supportant au moins un autre composant semi-conducteur.

8. Module électronique selon l'une des revendications 1 à 7, **caractérisé en ce que** le circuit électrique est une antenne réalisée sur la surface de la première face dudit film support diélectrique (11).

9. Module électronique selon l'une des revendications 3 à 8, **caractérisé en ce que** le composant semi-conducteur (15) est fixé sur ladite première face dudit film support diélectrique (11), de sorte qu'il soit décentré par rapport au centre du bornier de connexion formé par les plages de contact (12).

10. Procédé de fabrication d'un module électronique (10) comprenant un film support portant des pistes conductrices, un composant semi-conducteur connecté aux pistes conductrices, ledit procédé comprenant une étape d'impression des pistes conductrices (20) sur une première face du film support diélectrique (11) par un procédé d'impression, de report et de connexion d'un composant semi-conducteur (15) aux pistes conductrices par des connexions, caractérisé en ce chaque connexion est réalisée par un fil conducteur électrique (19 ; 24) reliant un plot du composant semi-conducteur à chaque piste directement ou par l'intermédiaire d'un îlot ou d'une plage d'interconnexion (17).

11. Procédé selon la revendication 10, **caractérisé en ce qu'**il comprend en outre une étape préalable consistant à assembler une couche métallisée sur une deuxième face du film support diélectrique (11), à réaliser une pluralité de plages de contact (12) électriques dans ladite couche métallisée, et à connecter électriquement ledit composant semi-conducteur (15) auxdites plages de contact (12) électriques.

12. Procédé selon l'une des revendications 10 à 11, **caractérisé en ce que** la deuxième extrémité (22) de chaque piste conductrice (20) imprimée est réalisée sur une surface telle, qu'elle forme une plage d'interconnexion destinée à être électriquement connectée à une borne d'interconnexion dudit circuit électrique.

13. Procédé selon l'une des revendications 10 à 12, **caractérisé en ce que** chaque extrémité du fil conducteur (19) est fixée d'une part sur un plot de contact du composant semi-conducteur (15) et d'autre part sur un îlot de contact (17) électrique, dont les contours sont préalablement délimités dans une plage de contact (12), en passant à travers une réservation (18) pratiquée dans l'épaisseur du film diélectrique (11) au regard dudit îlot de contact (17), de sorte qu'il relie électriquement ledit plot de contact du composant semi-conducteur (15) audit îlot de contact (17), et **en ce que** la première extrémité (21) de la piste conductrice (20) à relier est imprimée sur la surface dudit îlot de contact (17) dans ladite réservation (18) et débouche sur la face du film diélectrique (11) supportant ledit composant semi-conducteur (15).

14. Procédé selon l'une des revendications 10 à 13, **caractérisé en ce que** l'impression des pistes conductrices (20) est réalisée par l'une des techniques suivantes : jet d'encre, spray, LIFT, sérigraphie, flexographie ou encore héliographie.

15. Dispositif électronique (50) comprenant un circuit électrique (54) noyé dans son corps, et un module électronique (10) inséré dans une cavité (53) ménagée dans son corps, ledit circuit électrique comprenant des bornes d'interconnexion (55) à connecter audit module (10), **caractérisé en ce que** le module électronique (10) est conforme au module selon l'une au moins des revendications 1 à 9, ses plages d'interconnexion formées par la deuxième extrémité (22) des pistes conductrices (20) imprimées sur le film diélectrique (11) sont disposées en regard des bornes d'interconnexion (55) dudit circuit électrique et la connexion électrique (25) entre lesdites plages d'interconnexion (22) dudit module (10) et lesdites bornes d'interconnexion (55) dudit circuit électrique (54) comprend un matériau conducteur électrique.

16. Dispositif électronique selon la revendication 15, **caractérisé en ce qu'**il constitue un dispositif mixte à fonctionnement à contact et/ou sans contact, ou un dispositif interconnecté multi-composants.

## Patentansprüche

1. Elektronisches Modul (10), das eine dielektrische Trägerfolie (11) mit einer ersten Fläche, Leiterbahnen (20), die durch Drucken von leitendem Material auf die erste Fläche gefertigt sind, ein Halbleiterbauelement (15), das die Bahnen mittels elektrischer Verbindungen verbindet, umfasst, **dadurch gekennzeichnet, dass** jede Verbindung einen elektrisch leitenden Draht (19; 24) umfasst, der einen Höcker des Halbleiterbauelements mit jeder Bahn direkt oder über eine Insel oder einen Anschlussbereich (17) verbindet.

2. Elektronisches Modul nach Anspruch 1, **dadurch gekennzeichnet, dass** jede Leiterbahn (20) ein zweites Ende (22) umfasst, das einen Anschlussbereich bildet, der dazu bestimmt ist, mit einer Anschlussklemme der elektrischen Schaltung elektrisch verbunden zu sein.

3. Elektronisches Modul nach einem der Ansprüche 1 bis 2, **dadurch gekennzeichnet, dass** die dielektrische Trägerfolie (11) auf einer zweiten Fläche ferner eine Vielzahl elektrischer Kontaktbereiche (12) trägt, wobei das Halbleiterbauelement (15) mit den elektrischen Kontaktbereichen (12) elektrisch verbunden ist.

4. Elektronisches Modul nach den Ansprüchen 1 und 3, **dadurch gekennzeichnet, dass** ein erstes Ende des leitenden Drahts (19) auf dem Kontakthöcker des Halbleiterbauelements (15) befestigt ist, wohingegen das andere Ende des leitenden Drahts (19) eine Aussparung (18) durchquert, die in der Stärke der dielektrischen Folie (11) gegenüber einer Kontaktinsel (17), die in einem Kontaktbereich (12) angelegt ist, begrenzt und auf der Kontaktinsel (17) befestigt ist, und dadurch, dass das erste Ende (21) der gedruckten Leiterbahn (20) in der Aussparung (18) auf der Oberfläche der Kontaktinsel (17) gefertigt ist und an der Oberfläche der ersten Fläche der dielektrischen Trägerfolie (11) mündet.

5. Elektronisches Modul nach einem der Ansprüche 1 bis 4, **dadurch gekennzeichnet, dass** das Material, aus dem die gedruckten Leiterbahnen (20) bestehen, mit dem Material, aus dem der Leiterdraht (19; 24) besteht, kompatibel ist und umgekehrt.

6. Elektronisches Modul nach einem der Ansprüche 1 bis 5, **dadurch gekennzeichnet, dass** das Material, aus dem die gedruckten Leiterbahnen (20) bestehen, eine leitfähige Tinte ist, die metallische Nanopartikel umfasst, die auf mindestens einem der folgenden Metalle basieren: Gold, Silber, Kupfer, Aluminium, Palladium, oder Gemischen auf der Basis von Kupfernanopartikeln, die mit Zinn beschichtet sind, von Kupfernanopartikeln, die mit Silber beschichtet sind, von Kupfernanopartikeln, die mit Palladium beschichtet sind, oder auch von Kupfernanopartikeln, die mit einer Ni/Au-Schicht beschichtet sind.

7. Elektronisches Modul nach einem der Ansprüche 1 bis 6, **dadurch gekennzeichnet, dass** die elektrische Schaltung eine Hochfrequenzantenne, eine Ultrahochfrequenzantenne und/oder eine beliebige elektrische Schaltung umfasst, die mindestens ein anderes Halbleiterbauelement trägt.

8. Elektronisches Modul nach einem der Ansprüche 1 bis 7, **dadurch gekennzeichnet, dass** die elektrische Schaltung eine Antenne ist, die auf der Oberfläche der ersten Fläche der dielektrischen Trägerfolie (11) gefertigt ist.

9. Elektronisches Modul nach einem der Ansprüche 3 bis 8, **dadurch gekennzeichnet, dass** das Halbleiterbauelement (15) auf der ersten Fläche der dielektrischen Trägerfolie (11) derart befestigt ist, dass es in Bezug auf die Mitte der Anschlussleiste, die von den Kontaktbereichen (12) gebildet ist, außermittig ist.

10. Verfahren zur Herstellung eines elektronischen Moduls (10), das eine Trägerfolie, die Leiterbahnen trägt, ein Halbleiterbauelement, das mit den Leiterbahnen verbunden ist, umfasst, wobei das Verfahren einen Schritt des Druckens der Leiterbahnen (20) auf eine erste Fläche des dielektrischen Trägerfilms (11) durch ein Druckverfahren, des Übertragens und des Verbindens eines Halbleiterbauelements (15) mit den Leiterbahnen durch Verbindungen umfasst, **dadurch gekennzeichnet, dass** jede Verbindung durch einen elektrisch leitenden Draht (19; 24) gefertigt wird, der einen Höcker des Halbleiterbauelements mit jeder Bahn direkt oder über eine Insel oder einen Anschlussbereich (17) verbindet.

11. Verfahren nach Anspruch 10, **dadurch gekennzeichnet, dass** es ferner einen vorhergehenden Schritt umfasst, der darin besteht, eine metallisierte Schicht auf eine zweite Fläche des dielektrischen Trägerfilms (11) aufzubringen, eine Vielzahl elektrischer Kontaktbereiche (12) in dieser metallisierten Schicht zu fertigen und das Halbleiterbauelement (15) mit den elektrischen Kontaktbereichen (12) elektrisch zu verbinden.

12. Verfahren nach einem der Ansprüche 10 bis 11, **dadurch gekennzeichnet, dass** das zweite Ende (22) jeder gedruckten Leiterbahn (20) derart auf einer Oberfläche gefertigt wird, dass es einen Anschlussbereich bildet, der dazu bestimmt ist, mit einer Anschlussklemme der elektrischen Schaltung elektrisch verbunden zu werden.

13. Verfahren nach einem der Ansprüche 10 bis 12, **dadurch gekennzeichnet, dass** jedes Ende des leitenden Drahts (19) zum einen auf einem Kontakthöcker des Halbleiterbauelements (15) und zum anderen auf einer elektrischen Kontaktinsel (17), deren Konturen vorab in einem Kontaktbereich (12) abgegrenzt werden, befestigt ist, indem er eine Aussparung (18) durchquert, die in der Stärke der dielektrischen Folie (11) gegenüber der Kontaktinsel (17) derart angelegt ist, dass er den Kontakthöcker des Halbleiterbauelements (15) mit der Kontaktinsel (17) elektrisch verbindet, und dass das erste Ende (21) der Leiterbahn (20), die zu verbinden ist, auf die Oberfläche der Kontaktinsel (17) in der Aussparung (18) gedruckt wird und auf der Fläche der dielektrischen Folie (11), die das Halbleiterbauelement (15) bildet, mündet.

14. Verfahren nach einem der Ansprüche 10 bis 13, **dadurch gekennzeichnet, dass** das Drucken der Leiterbahnen (20) durch eine der folgenden Techniken ausgeführt wird: Tintenstrahl, Spray, LIFT, Siebdruck, Flexodruck oder auch Heliografie.

15. Elektronische Vorrichtung (50), die eine elektrische Schaltung (54), die in ihrem Körper eingelassen ist, und ein elektronisches Modul (10), das in einen Hohlraum (53), der in ihrem Körper eingerichtet ist, umfasst, wobei die elektrische Schaltung Anschlussklemmen (55) umfasst, die mit dem Modul (10) zu verbinden sind, **dadurch gekennzeichnet, dass** das elektronische Modul (10) dem Modul nach mindestens einem der Ansprüche 1 bis 9 entspricht, wobei seine Anschlussbereiche, die von dem zweiten Ende (22) der Leiterbahnen (20), die auf der dielektrischen Folie (11) gedruckt sind, gebildet sind, gegenüber den Anschlussklemmen (55) der elektrischen Schaltung angeordnet sind, und die elektrische Verbindung (25) zwischen den Anschlussbereichen (22) des Moduls (10) und den Anschlussklemmen (55) der elektrischen Schaltung (54) ein elektrisch leitendes Material umfasst.

16. Elektronische Vorrichtung nach Anspruch 15, **dadurch gekennzeichnet, dass** sie eine gemischte Vorrichtung mit kontaktgebundenem und/oder kontaktlosem Betrieb oder eine Mehrkomponenten-Verbundvorrichtung bildet.

## Claims

1. Electronic module (10) comprising a dielectric support film (11) with a first face, conductive tracks (20) produced by printing conductive material on said first face, a semiconductor component (15) connecting said tracks by means of electrical connections, **characterized in that** each connection comprises an electrical conductive wire (19, 24) connecting a stud of the semiconductor component to each track directly or through an island or an interconnection pad (17).

2. Electronic module according to claim 1, **characterized in that** each conductive track (20) comprises a second end (22) forming an interconnection pad intended for being electrically connected to an interconnection terminal of said electrical circuit.

3. Electronic module according to one of claims 1 to 2, **characterized in that** the dielectric support film (11) also has, on a second face, a plurality of electrical contact pads (12), said semiconductor component (15) being electrically connected to said electrical contact pads (12).

4. Electronic module according to claims 1 and 3, **characterized in that** a first end of the conductive wire (19) is attached to the contact stud of said semiconductor component (15) while the other end of the conductive wire (19) passes through a via (18), made in the body of the dielectric film (11) facing a contact island (17) defined in a contact pad (12), and is attached to said contact island (17), and **in that** the first end (21) of the printed conductive track (20) is produced in said via (18), on the surface of said contact island (17), and opens onto the surface of the first face of said dielectric support film (11).

5. Electronic module according to one of claims 1 to 4, **characterized in that** the material that constitutes the printed conductive tracks (20) is compatible with the material that constitutes the conductive wire (19, 24) and vice versa.

6. Electronic module according to one of claims 1 to 5, **characterized in that** the material of the printed conductive tracks (20) is a conductive ink comprising metal nanoparticles of at least one of the following metals: gold, silver, copper, aluminium, palladium, or mixtures based on copper nanoparticles coated with tin, copper nanoparticles coated with silver, copper nanoparticles coated with palladium, or even copper nanoparticles coated with a layer of Ni/Au.

7. Electronic module according to one of claims 1 to 6, **characterized in that** the electrical circuit comprises a radio frequency antenna, an ultra-high frequency antenna, and/or any electrical circuit supporting at least one other semiconductor component.

8. Electronic module according to one of claims 1 to 7, **characterized in that** the electrical circuit is an antenna produced on the surface of the first face of said dielectric support film (11).

9. Electronic module according to one of claims 3 to 8, **characterized in that** the semiconductor component (15) is attached to said first face of said dielectric support film (11), so that it is off-centre with respect to the centre of the connection terminal block formed by the contact pads (12).

10. Method for manufacturing an electronic module (10) comprising a support film having conductive tracks, a semiconductor component connected to the conductive tracks, said method comprising a step of printing conductive tracks (20) on a first face of the dielectric support film (11) by a process of printing, transferring and connecting a semiconductor component (15) to the conductive tracks by means of connections, **characterized in that** each connection is produced by an electrically conductive wire (19, 24) connecting a stud of the semiconductor component to each track directly or via an island or an interconnection pad (17).

11. Method according to claim 10, **characterized in that** it further comprises a preliminary step consisting in assembling a metallized layer on a second face of the dielectric support film (11), in producing a plurality of electrical contact pads (12) in said metallized layer, and in electrically connecting said semiconductor component (15) to said electrical contact pads (12).

12. Method according to one of claims 10 to 11, **characterized in that** the second end (22) of each printed conductive track (20) is produced on a surface such that it forms an interconnection pad intended for being electrically connected to an interconnection terminal of said electrical circuit.

13. Method according to one of claims 10 to 12, **characterized in that** each end of the conductive wire (19) is attached to a contact stud of the semiconductor component (15) as well as to an electrical contact island (17), the contours of which are defined beforehand in a contact pad (12), passing through a via (18) made in the body of the dielectric film (11) facing said contact island (17), so that it electrically connects said contact stud of the semiconductor component (15) to said contact island (17), and **in that** the first end (21) of the conductive track (20) to be connected is printed on the surface of said contact island (17) in said via (18) and opens onto the face of the dielectric film (11) supporting said semiconductor component (15).

14. Method according to one of claims 10 to 13, **characterized in that** the conductive tracks (20) are printed by one of the following techniques: inkjet, spray, LIFT, screen printing, flexography or even heliography.

15. Electronic device (50) comprising an electrical circuit (54) embedded in its body, and an electronic module (10) inserted in a cavity (53) formed in its body, said electrical circuit comprising interconnection terminals (55) to be connected to said module (10), **characterized in that** the electronic module (10) is consistent with the module according to at least one of claims 1 to 9, its interconnection areas formed by the second end (22) of the conductive tracks (20) printed on the dielectric film (11) are arranged facing the interconnection terminals (55) of said electrical circuit and the electrical connection (25) between said interconnection pads (22) of said module (10) and said interconnection terminals (55) of said electrical circuit (54) comprise an electrically conductive material.

16. Electronic device according to claim 15, **characterized in that** it constitutes a mixed device with contact and/or contactless operation, or an interconnected multi-component device.
